# EUROPEAN PATENT APPLICATION

(11) **EP 4 270 442 A1**
(43) Date of publication of application: **01.11.2023**
(21) Application number: 20967351.6
(22) Date of filing: 28.12.2020
(51) Int. Cl.: H01J 37/20, H01J 37/244

(54) **MICROSCOPE SAMPLE STAGE**

(71) Applicant: Bioland Laboratory, Guangzhou, Guangdong 510320 (CN); INSTITUTE OF BIOPHYSICS, CHINESE ACADEMY OF SCIENCES, Chaoyang District Beijing 100101 (CN)
(72) Inventor: CAO, Feng, Guangzhou, Guangdong 510320 (CN); LI, Kuan, Guangzhou, Guangdong 510320 (CN); LU, Shiyi, Guangzhou, Guangdong 510320 (CN); LI, Xiquan, Guangzhou, Guangdong 510320 (CN); SUN, Sijia, Guangzhou, Guangdong 510320 (CN); YAO, Yifan, Guangzhou, Guangdong 510320 (CN); LU, Zhigang, Guangzhou, Guangdong 510320 (CN); ZHANG, Qirong, Guangzhou, Guangdong 510320 (CN); LIU, Jikai, Guangzhou, Guangdong 510320 (CN); SUN, Fei, Guangzhou, Guangdong 510320 (CN)
(74) Representative: dompatent von Kreisler Selting Werner - Partnerschaft von Patent- und Rechtsanwälten mbB
(86) International application number: PCT/CN2020/140426
(87) International publication number: WO 2022/141001

(57) **Abstract**

A microscope sample stage, comprising: a base (1); a three-dimensional motion mechanism arranged on the base (1), wherein the three-dimensional motion mechanism can move in a first direction, a second direction and a third direction; a supporting structure, which is arranged on the three-dimensional motion mechanism and can rotate about a shaft parallel to the third direction; and a sample holder placement portion (51), which is arranged on the supporting structure. The supporting structure comprises a locking mechanism, by means of which a sample holder (6) is fixed. The sample stage is small in space occupied and large in sample capacity, the position of a sample can be adjusted in a three-dimensional manner, the sample holder (6) can be automatically locked and unlocked, and the temperature of the sample can be controlled.

## Description

### Technical Field

The present invention relates to the field of microscope technologies, and in particular, to a microscope sample stage.

### Background Art

Electron microscopy is a technique for microscopic imaging and in situ analysis using electron optics systems. The characteristic of an electron microscope is that it can directly observe the morphology, structure, and composition of the sample at extremely high magnification; has high resolution and can directly distinguish atoms for nanoscale crystal structure and composition analysis; the development direction tends to be multifunctional and comprehensive.

The electron microscope sample stage is a device used in the electron microscope system to carry the sample to be tested. Most of the existing electronic microscope sample stages use a larger XY axis movement stroke to observe multiple samples at once, resulting in a larger volume of the electron microscope, especially the sample chamber. At the same time, the number of samples carried by the sample stage of the existing technology is still limited. When the number of observed samples is large, it is necessary to manually replace the samples frequently, and after each sample replacement, it need to perform equipment vacuum pumping, readjust the observation position and focal length of the samples, and other operations. In addition, existing technology still requires manual locking and confirmation of sample installation stability during the sample replacement process to prevent sample holders from falling off during the observation process. There is a lack of devices that can automatically lock, unlock, and clamp the sample holders, which affects the observation effect, reduces efficiency, consumes time, and manpower.

### Summary

In order to solve the problems existing in the prior art mentioned above, the present invention provides a microscope sample stage. The sample stage is small in space occupied and large in sample capacity, the position of a sample can be adjusted in a three-dimensional manner, and the temperature of the sample can be controlled. Through the locking structure, the sample stage and sample holder can be automatically locked and unlocked, and the locking status can be detected in real-time. The sample holder can be fully automatically unlocked and replaced, and the sample holder can be automatically locked after replacement. It is particularly suitable for application scenarios of electron microscopes without the need for human intervention.

The present invention provides a microscope sample stage, including:
a base;
a three-dimensional motion mechanism provided on the base, where the three-dimensional motion mechanism can move in a first direction, a second direction and a third direction;
a supporting structure, which is provided on the three-dimensional motion mechanism and can rotate about a shaft parallel to the third direction;
a sample holder placement portion, which is provided on the supporting structure; where
the supporting structure includes a locking mechanism, by means of which the sample holder is fixed.

Optionally, the supporting structure includes a fourth supporting structure, which is provided on the three-dimensional motion mechanism and can rotate about a shaft parallel to the third direction.

Optionally, the locking mechanism includes at least two claw heads and a reset component respectively connected to the claw heads.

Optionally, the supporting structure includes a fifth driving mechanism which is configured to drive the locking mechanism locking or unlocking.

Optionally, the fifth driving mechanism includes a transmission component, a steering component, and a power component, where one end of the transmission component contacts the claw heads in a locked state and drives the claw heads to move outward along the cross-sectional center of the supporting structure, detaching from the claw heads in an unlocked state, the other end of the transmission component is connected to the steering component, one end of the steering component is connected to the transmission component, and the other end of the steering component is connected to the power component.

Optionally, the three-dimensional motion mechanism includes a first motion mechanism and a second motion mechanism, where the first motion mechanism is capable of driving the supporting structure to move in the first direction and the second direction, and the second motion mechanism is capable of driving the supporting structure to move in the third direction.

Optionally, the three-dimensional motion mechanism more particularly includes: a first supporting structure provided on the base and capable of moving in the first direction relative to the base;
a second supporting structure provided on the first supporting structure and capable of moving in the second direction relative to the first supporting structure;
a third supporting structure provided on the second supporting structure and capable of moving in the third direction relative to the second supporting structure.

Optionally, the upper surface of the base has an inward concave shape and includes a first guide rail provided in the first direction on the two opposite sidewalls of the concave, and the lower surface of the first supporting structure has a first sliding component that is matched with the first guide rail.

Optionally, a first driving mechanism is provided on one sidewall of the base, configured to drive the movement of the first supporting structure; and/or
the other sidewall of the base is provided with a first grating ruler, and the lower surface of the corresponding position of the first supporting structure is provided with a grating ruler reading head, configured to measure the relative displacement between the base and the first supporting structure.

Optionally, the upper surface of the first supporting structure has an inward concave shape, and includes a second guide rail provided along the second direction on the two opposite sidewalls of the concave, and the lower surface of the second supporting structure has a second sliding component that is matched with the second guide rail.

Optionally, a second driving mechanism is provided on the sidewall of the first supporting structure, configured to drive the movement of the second supporting structure; and/or
the other sidewall of the first supporting structure is provided with a first grating ruler, and the lower surface of the corresponding position of the second supporting structure is provided with a grating ruler reading head, configured to measure the relative displacement between the first supporting structure and the second supporting structure.

Optionally, the third supporting structure is movably connected to the second supporting structure through a fixing portion fixed to the second supporting structure.

Optionally, a third driving mechanism is provided on the another surface of the fixing portion, which is opposite to the surface of the fixing portion where the third supporting structure is installed, configured to drive the movement of the third supporting structure.

Optionally, the upper surface of the third supporting structure is provided with a fourth driving mechanism, configured to drive the rotation of the fourth supporting structure.

Optionally, the fifth driving mechanism further includes a sensor.

Optionally, the sample stage further includes a sample holder, where the sample holder includes:
main body;
a plurality of sample bearing positions which are provided along the edges of the main body.

Optionally, the main body is in the shape of a disc or a hollow disc; and/or
the sample bearing positions are provided in a circular shape centered on the geometric center of the main body; and/or
the sample bearing positions are provided equidistantly along the edges of the main body; and/or
the sample holder includes more than ten sample carrying positions.

Optionally, the sample holder further includes a first identification mark, a second identification mark, and a third identification mark provided on the main body, where:
the first identification mark and the second identification mark are adhered on the upper surface of the main body; and/or
the first identification mark and the second identification mark are provided with one or more positioning lines or raised stripes on the respective upper surface; and/or
the combination of the first identification mark and the second identification mark is configured to construct a sample holder positioning coordinate system; and/or
the third identification mark is configured to indicate the placement direction of the sample holder.

Optionally, the sample holder further includes a temperature control structure provided on the main body, where the temperature control structure includes any one or more of the following: pipelines, hidden grooves, and resistance slurry patterns.

Optionally, the pipeline includes a circular pipeline provided along a circle centered on the geometric center of the main body;
the hidden groove includes a circular hidden groove provided along a circle centered on the geometric center of the main body;
the resistance slurry pattern is a circular shape provided along a circle centered on the geometric center of the main body, and includes a first insulation layer, a resistance slurry pattern, and a second insulation layer sequentially stacked from the surface of the main body.

Optionally, the angle of each other between the first direction, the second direction, and the third direction is between 60 ° and 120 °; or
the first direction, the second direction, and the third direction are orthogonal to each other.

The electron microscope sample stage provided by the present invention has the following advantages:
In a solution of the embodiment of the present disclosure, through the movable connection between the base and the first supporting structure, the second supporting structure, the third supporting structure and the fourth supporting structure, the sample placed on the sample platform can be adjusted in three-dimensional space, so that observer can easily observe various parts of the sample. By setting up a movable sample holder placement portion, the sample holder can be flexibly and quickly picked up and placed.

In a solution of the embodiment of the present disclosure, by setting a guide rail at the connection of each support structural which cooperate with the driving mechanism, the transmission can be carried out through the worm shaft and worm, and a grating ruler is set to measure the relative displacement distance between each platform, which eliminates the process of manually adjusting the sample platform, making the sample platform displacement adjustment more convenient and accurate.

In a solution of the embodiment of the present disclosure, the locking structure can achieve automatic locking and unlocking the sample stage with sample holder, and real-time detecting the locking status. It can achieve fully automatic unlocking and replacement of the sample holder, and automatic locking of the sample holder after replacement without human intervention.

In a solution of the embodiment of the present disclosure, by setting the sample bearing position at the edge of the sample holder or in a circular shape, the number of samples carried by the sample position can be significantly increased, allowing observer to observe more samples after replacing the observation sample holder in one times, greatly saving observer time and labor costs. Through the collaboration of the first to fourth supporting structures and sample holders, the sample can be adjusted arbitrarily in three-dimensional space to meet the observation requirements of the microscope. Under the same observation requirements, the observer can position a sample by adjusting the horizontal or vertical position of the sample holder only once. In the subsequent observation, the samples can be switched by rotating the sample holder without changing the spatial position of the sample observation position relative to the microscope, avoiding frequent adjustment of the horizontal or vertical position of the sample holder, simplifying the operation process of the electron microscope and saving the time of the observer.

In a solution of the embodiment of the present disclosure, by setting a first identification mark and a second identification mark on the sample holder, when image recording and archiving of the sample is required, the image of the sample holder after optical photography can be processed in coordinate system, and the image features of each sample can be accurately positioned and measured. The third identification mark is configured to inform the observer of the placement direction of the sample holder and indicate the position of the initial sample bearing position.

In a solution of the embodiment of the present disclosure, the temperature control structure of the sample holder can heat or cool the sample holder and the samples on the sample holder, which can be suitable for observation of samples with special requirements.

### Brief Description of the Drawings

Fig. 1 is a structural diagram of a microscope sample stage according to one embodiment of the present invention;
Fig. 2 is a structural diagram of a microscope sample stage according to another embodiment of the present invention;
Fig. 3 is a structural diagram of a microscope sample stage according to yet another embodiment of the present invention;
Fig. 4 is a structural diagram of a microscope sample stage according to still another embodiment of the present invention;
Figs. 5 and 6 are structural diagrams of the fourth supporting structure of a microscope sample stage according to an embodiment of the present invention;
Fig. 7 is a sample holder structure diagram of an embodiment of the present invention.

### Detailed Description of the Embodiments

In order to make the purpose, technical solution, and advantages of the present invention clearer, the following is a detailed explanation of the present invention in conjunction with particular embodiments and with reference to the accompanying drawings.

In an embodiment of this example, the microscope sample stage includes:
a base 1;
a three-dimensional motion mechanism provided on the base 1, where the three-dimensional motion mechanism can move in a first direction, a second direction and a third direction;
a supporting structure, which is provided on the three-dimensional motion mechanism and can rotate about a shaft parallel to the third direction;
a sample holder placement portion, which is provided on the supporting structure;
the supporting structure includes a locking mechanism, by means of which a sample holder is fixed.

Base 1 is located below the three-dimensional motion mechanism and is configured to support the three-dimensional motion mechanism. The three-dimensional motion mechanism can move in the first direction, the second direction, and the third direction relative to the base. The supporting structure is located at the top or inside of the three-dimensional motion mechanism and can be driven by the three-dimensional motion mechanism to move in the first direction, the second direction, and the third direction. The supporting structure can rotate relative to the three-dimensional motion mechanism and/or the base around an axis parallel to the third direction, where the supporting structure can rotate relative to the three-dimensional motion mechanism or the supporting structure and three-dimensional motion mechanism can rotate together relative to the base. The top of the supporting structure is fixedly equipped with a sample holder placement portion for placing the sample holder. The supporting structure includes a locking mechanism, which is located inside the supporting structure, with one end of it located in the sample holder placement portion for locking or unlocking the sample holder placed in the sample holder placement portion.

In a particular embodiment, the supporting structure includes a fourth supporting structure 5 provided on the three-dimensional motion mechanism and can rotate about a shaft parallel to the third direction.

In an embodiment of this example, the fourth supporting structure 5 includes a locking mechanism, which includes a reset component 52 and at least two claw heads 53. The fourth supporting structure 5 further includes a housing 50 and a fifth driving mechanism, where the locking mechanism is located inside the housing 50, and the fifth driving mechanism is located at one end of the locking mechanism far from the sample holder placement portion 51. The fifth driving mechanism is configured to drive the locking mechanism to expand or contract relative to the center of the cross-section of the fourth supporting structure, enabling the locking mechanism to achieve the locking and unlocking of the sample holder. The locking mechanism is detachably connected to the sample holder 6 at one end far away from the fifth driving mechanism, and the sample holder 6 is fixed on the locking mechanism through the locking mechanism.

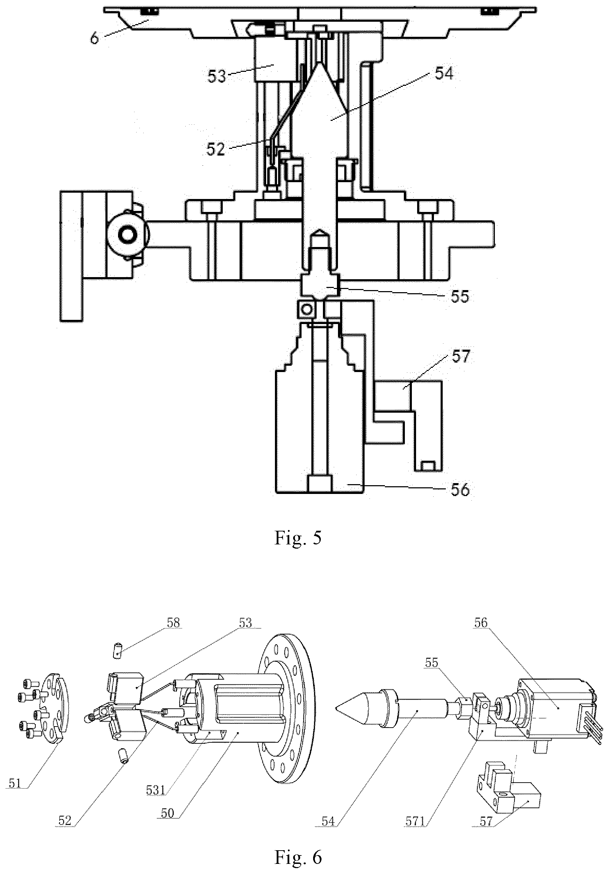

In an embodiment of this example, as shown in Figs. 5 and 6, the housing 50 is a hollow structure, and the reset component 52 of the locking mechanism and at least two claw heads 53 are provided inside the housing 50. For example, the locking mechanism can be encapsulated within the housing 50 by the sample holder placement portion 51.

The claw head 53 is provided at one end of the fourth supporting structure near the sample holder placement portion. At one end of the housing 50 near the sample holder placement portion 51, a slot 531 is provided to match the claw head 53, which can move radially relative to the slot 531 along the cross-sectional center of the fourth supporting structure. The outer side of the claw head 53 is provided with a protrusion, such as a fastening screw 58, for supporting the protrusion at the bottom of the sample holder to enhance the locking effect with the sample holder.

One end of the reset component 52 is fixed to the claw head 53, and the other end is fixed to the housing 50. The claw head 53 can move radially in different directions along the section center of the fourth supporting structure. Among them, in the locked state, the claw head 53 moves outward relative to the cross-sectional center of the fourth supporting structure, and the fastening screw 58 contacts the protrusion of the sample holder bottom and locks the sample holder. In the unlocked state, the reset component 52 drives the claw head 53 to move inward towards the center of the fourth supporting structure section, and the fastening screw 58 disengages from the protrusion at the bottom of the sample holder and unlocks the sample holder. The reset component 52 can be an elastic component such as a spring, elastic rubber, or spring piece, and is not limited here.

In an embodiment of this example, the fifth driving mechanism includes a transmission component 54, a steering component 55, and a power component 56. The transmission component 54 contacts with the claw head 53 at its one end in a locked state and drives the claw head 53 to move outward along the center of the fourth supporting structure section, where in an unlocked state, disengages from the claw head 53. The other end of the transmission component 54 is connected to the steering component 55, and one end of the steering component 55 is connected to the transmission component 54, the other end connected to the power component 56.

For example, the end of the transmission component 54 near the claw head 53 is configured as a cone. The steering component 55 may be a universal ball or a universal joint, etc, whose function is that when the sample holder 6, the locking mechanism and the transmission component 54 need to rotate horizontally, the power component 56 does not need to follow the rotation and can continuously control the locking state of the locking mechanism. The working principle is that when the sample holder 6 needs to be locked, the power component 56 drives the transmission component 54 and the steering component 55 to move in the direction toward the locking mechanism, and the cone end of the transmission component 54 pushes the locking mechanism to enter the locking state. When the sample holder 6 needs to be unlocked, the power component 56 drives the transmission component 54 and the steering component 55 to move away from the locking mechanism, and the reset component 52 drives the locking mechanism to enter the unlocked state.

In an embodiment of this example, the fifth driving mechanism further includes a sensor 57 and a sensor mounting seat 571, where one end of the sensor mounting seat 571 is fixed on one side of the power component 56 and the other end is close to the transmission component 54. The sensor 57 is installed on the side of the sensor mounting seat 571 near to the transmission component 54. The sensor 57 is configured to detect the position of the transmission component 54 to determine the status of the locking mechanism.

In an embodiment of this example, the three-dimensional motion mechanism includes a first motion mechanism and a second motion mechanism, where the first motion mechanism is capable of driving the supporting structure to move in the first and second directions, and the second motion mechanism is capable of driving the supporting structure to move in the third direction. The first motion mechanism includes two tracks, a first track and second track, which are not parallel to each other. The first track is parallel to the first direction, and the second track is parallel to the second direction. The first track is located below the second track and stacked up and down, allowing the second track to move back and forth in the first direction. The second motion mechanism can be located at the top of the second track, configured to drive the supporting structure to move in the third direction, without specific restrictions here, as long as it can achieve three-dimensional motion. For example, the three-dimensional motion mechanism in CN202061777U and CN105575240A can also be introduced into this application.

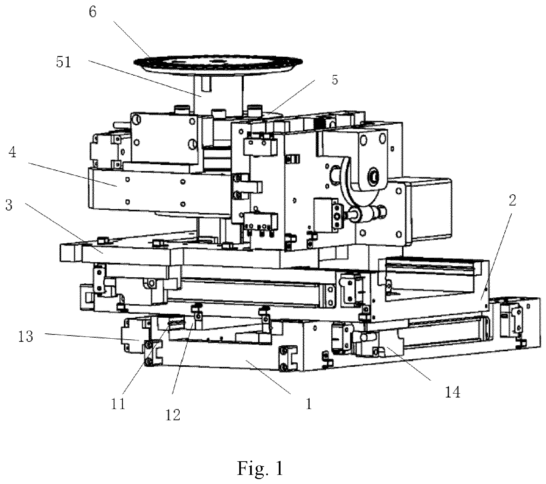

In a more particular embodiment of this example, the microscope sample stage is shown in Fig. 1, and the three-dimensional motion mechanism includes:
a first supporting structure 2 provided on the base 1 and capable of moving in the first direction relative to the base 1;
a second supporting structure 3 provided on the first supporting structure 2 and capable of moving in the second direction relative to the first supporting structure 2;
a third supporting structure 4 provided on the second supporting structure 3 and capable of moving in the third direction relative to the second supporting structure 3.

The supporting structure includes:
a fourth supporting structure 5 provided on the third supporting structure 4 and capable of rotating around an axis parallel to the third direction;
among them, the first direction, the second direction, and the third direction are not parallel to each other.

In an embodiment of this example, the base 1 is connected to the first supporting structure 2, and by a sliding device connection, the first supporting structure 2 can reciprocate in the first direction relative to the base 1, with a distance of reciprocation less than the length of the base 1 in the first direction. The first supporting structure 2 and the second supporting structure 3 are interconnected and by a sliding device connection, the second supporting structure 3 can be reciprocate in the second direction relative to the first supporting structure 2, with a distance of reciprocation less than the length of the first supporting structure 2 in the second direction. The third supporting structure 4 is combined with the fourth supporting structure 5, and the third supporting structure 4 can make the fourth supporting structure 5 reciprocates in the third direction. The fourth supporting structure 5 is equipped with a vertically placed shaft that can rotate in a horizontal plane. The first direction, the second direction, and the third direction are not parallel to each other, forming a three-dimensional mobile platform.

In this example, the fourth supporting structure 5 is equipped with a sample holder placement portion 51. The placement portion is configured to place and fix the sample holder 6 for observation.

In an embodiment of this example, the upper surface of the base 1 has an inward concave shape and includes a first guide rail 11 provided in the first direction on two opposite sidewalls of the concave, and the lower surface of the first supporting structure 2 has a first sliding component 12 that is matched with the first guide rail 11.

In an embodiment of this example, one side-wall of the base 1 is provided with a first driving mechanism 13 for driving the first supporting structure 2 to move; and/or
a first grating ruler 14 is provided on the outer wall of the other side of the upper surface concave 1 of base far away from the first driving mechanism 13, and a grating ruler reading head is provided on the lower surface of the corresponding position of the first supporting structure 2 to measure the relative displacement between the base 1 and the first supporting structure 2.

In this embodiment, the upper surface of the base 1 is inward concave, and on the two opposite sidewalls of the concave, a first guide rail 11 is provided on the inner wall or the top surface of the sidewall along the extension direction of the sidewall. The lower surface of the first supporting structure 2 is equipped with a first sliding component 12 that is matched with the first guide rail 11. The first guide rail 11 and the first sliding component 12 include a roller type guide rail, a ball type guide rail, a gear type guide rail, etc, and are not limited here. One sidewall of the base 1 is equipped with a first driving mechanism 13, which is fixed on the outer wall in one side of the upper surface concave of the base 1 and connected to the lower surface of the first supporting structure 2 through worm gears or other transmission structures. The displacement between the base 1 and the first supporting structure 2 can be finely adjusted, making it more suitable for application scenarios where small samples are observed under electron microscopes. A first grating ruler 14 is provided at the outer wall of the other side of the upper surface concave of the base 1, where the said other side is far away from the first driving mechanism 13, and the provided position is correspond to the first supporting structure 2. The first grating ruler 14 includes a ruler grating provided on the outer wall of the base 1 and a grating ruler reading head provided at a corresponding position on the lower surface of the first supporting structure 2. The first grating ruler 14 is parallel to the first guide rail 11. In the field of electron microscope, the objects observed are extremely tiny, so when the specimen moves, especially when it needs to be automatically controlled by the computer, it is necessary to accurately obtain the relative displacement data. In order to accurately measure the displacement distance of the platform and facilitate the transmission of displacement data to the observer, a grating ruler is set to transmit the displacement data of the base 1 and the first supporting structure 2 to the control component.

In an embodiment of this example, the sample stage further includes a controller for automatically controlling the movement of the base 1 and the first supporting structure 2. The controller, the first driving mechanism 13, and the first grating ruler 14 form a closed-loop control, and the closed-loop control method is as follows. Firstly the controller receives a target position command, and compares the received target position with the current position of the grating to obtain initial displacement data, then transmits the initial displacement data to the first driving mechanism 13. The first driving mechanism 13 drives the first supporting structure 2 to move relative to the base 1 based on the initial displacement data. After the displacement is completed, the first grating ruler 14 transmits the actual displacement data to the controller for comparison. If the actual displacement data is inconsistent with the initial displacement data, the above steps are repeated for further displacement until the initial displacement data is consistent with the actual displacement data. For example, when the controller receives the target position command as the first position and the current position as the second position, the controller compares the received first position with the second position, obtaining the first difference as the initial displacement data. Then, the first difference is input into the first driving mechanism 13, driving the first supporting structure 2 to move relative to the base 1. After the displacement is completed, the actual displacement data is transmitted to the controller for comparison. If the actual displacement data is the second difference and the position after displacement is the third position, then compare the third position with the first position again and repeat the above steps.

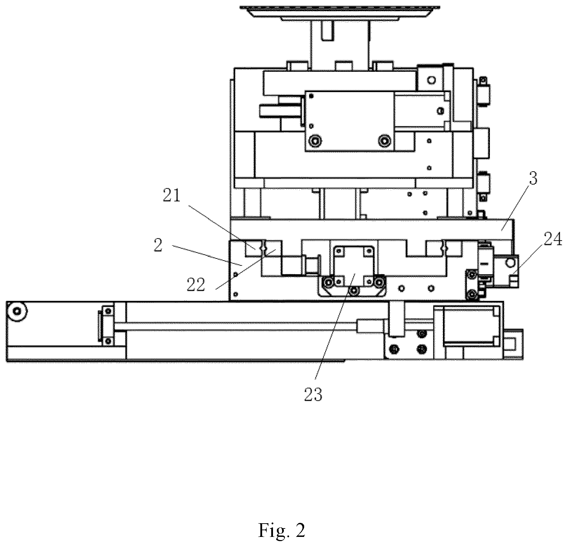

In an embodiment of this example, as shown in Fig. 2, the upper surface of the first supporting structure 2 has an inward concave shape and includes a second guide rail 21 provided in the second direction on two opposite sidewalls of the concave, and the lower surface of the second supporting structure 3 has a second sliding component 22 that is matched with the second guide rail 21.

In an embodiment of this example, a second driving mechanism 23 is provided in the middle depression on the upper surface of the first supporting structure 2 to drive the movement of the second supporting structure 3; and/or
the outer wall of the concave side of the first supporting structure 2 is equipped with a second grating ruler 24, and the lower surface of the corresponding position of the second supporting structure 3 is equipped with a grating ruler reading head for measuring the relative displacement between the first supporting structure 2 and the second supporting structure 3.

In this embodiment, the upper surface of the first supporting structure 2 is inwardly concave, and a second guide rail 21 is provided along the extension direction of the two inner walls on the two opposite sidewalls of the concave. The lower surface of the second supporting structure 3 is equipped with a second sliding component 22 that is matched with the second guide rail 21. The second guide rail 21 and the second sliding component 22 include a roller type guide rail, a ball type guide rail, a gear type guide rail, etc, and are not limited here. The middle depression on the upper surface of the first supporting structure 2 is equipped with a second driving mechanism 23. The second driving mechanism 23 is fixed in the middle depression on the upper surface of the first supporting structure 2, and is connected to the lower surface of the corresponding position of the second supporting structure 3 through a worm gear or other transmission structure, which can finely adjust the displacement of the first supporting structure 2 and the second supporting structure 3, more suitable for application scenarios where small samples are observed under an electron microscope. A second grating ruler 24 is provided at the corresponding position between the outer wall in one side of the upper surface concave on the first supporting structure 2 and the second supporting structure 3. The second grating ruler 24 includes a ruler grating provided on the outer wall of the other side of the upper surface concave on the first supporting structure 2 and a grating ruler reading head provided at the corresponding position on the lower surface of the second supporting structure 3. The second grating ruler 24 is parallel to the second guide rail 21. In the field of electron microscope, the objects observed are extremely tiny, so when the specimen moves, especially when it needs to be automatically controlled by the computer, it is necessary to accurately obtain the relative displacement data. In order to accurately measure the distance of the platform displacement, and facilitate the transmission of displacement data to the observer, the displacement data of the first supporting structure 2 and the second supporting structure 3 are transmitted to the control component through the grating ruler.

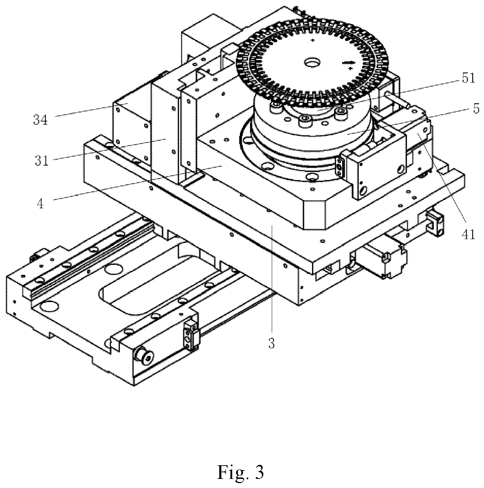

In an embodiment of this example, as shown in Fig. 3, the third supporting structure 4 is movably connected to the second supporting structure 3 by a fixing portion 31 fixed to the second supporting structure 3. The fixing portion 31 is a plate-like structure with an inward depression on one side, which is vertically fixed on one side of the surface of the second supporting structure. The depression direction is vertical and faces the third supporting structure 4.

In an embodiment of this example, the fixing portion 31 is provided with a third driving mechanism 34 on another surface opposite the surface on which the third supporting structure 4 is installed, for driving the movement of the third supporting structure 4.

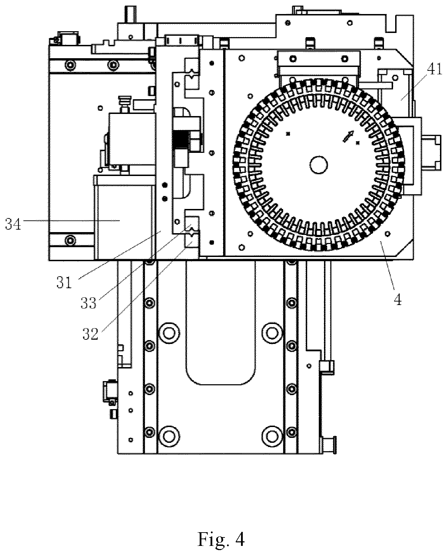

In an embodiment of this example, as shown in Figs. 3 and 4, the fixing portion 31 is vertically provided and fixed on one side of the upper surface of the second supporting structure 3. The side surface facing the third supporting structure 4 is inward concave, and the concave direction is vertical. The two opposite sidewalls of the concave are equipped with a third guide rail 32 along the vertical direction. The side surface of the third supporting structure 4 is equipped with a third sliding component 33 that is matched with the third guide rail, so enable the third supporting structure 4 to reciprocate in a vertical direction relative to the fixing portion 31 and the second supporting structure 3. A third driving mechanism 34 is provided at one side surface of the fixing portion 31, which side is far away from the third supporting structure 4, and the third driving mechanism 34 is connected with the third supporting structure 4 through a worm gear or other transmission structural joint to drive the third supporting structure 4 to move.

In an embodiment of this example, as shown in Fig. 3, the upper surface of the third supporting structure 4 is provided with a fourth driving mechanism 41 for driving the fourth supporting structure 5 to rotate. The fourth driving mechanism 41 is located at the edge of the upper surface of the third supporting structure 4, and is connected to the fourth supporting structure 5 through a worm gear or other transmission structure, which can drive the fourth supporting structure 5 to rotate in the horizontal direction.

In an embodiment of this example, the first driving mechanism 13, the second driving mechanism 23, the third driving mechanism 34, and the fourth driving mechanism 41 are any of the driving devices such as motors, piezoelectric ceramics, manual knobs, etc. In addition to the scheme described above, the specific forms and positions of the first, second, third, and fourth driving mechanisms can also be set according to actual needs.

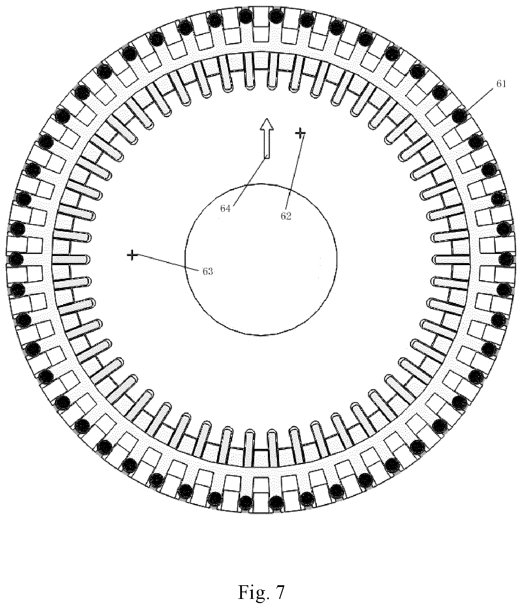

In an embodiment of this example, as shown in Fig. 7, the sample stage further includes a sample holder 6, which includes a main body. Multiple sample bearing positions 61 provided along the edges of the main body. In order to solve the problem of low observation efficiency, caused by the insufficient number of samples carried by the existing electron microscope sample stage, and frequently replacing samples by observer, sample bearing position 61 is set at the edge of the main body of sample holder 6, and the observation samples can be switched by rotating and/or translating the sample holder 6. This allows observer to observe more samples after replacing the observation sample holder 6, greatly saving observer's time and labor costs.

In an embodiment of this example, the main body is in the shape of a disc or a hollow disc; and/or
the sample bearing position 61 is provided along a circular shape centered on the geometric center of the main body; and/or
the sample bearing positions 61 are equidistant along the edges of the main body; and/or
the sample holder 6 includes more than ten sample holders.

In this embodiment, the main body is in the shape of a disc or a hollow disc, and/or the sample bearing position 61 is provided along a circular center centered on the geometric center of the main body. In practical application scenarios, this setting allows the observer to position a sample only by adjusting the horizontal or vertical position of sample holder 6 once, and then switch observed samples by rotating sample holder 6 for subsequent observation, avoiding frequent adjustment of the horizontal or vertical position of sample holder 6, simplifying the operation process of the electron microscope and saving observer time.

The sample bearing position 61 is equidistant along the edge of the main body, allowing the sample holder 6 to switch to the next sample bearing position 61 by rotating at the same angle. This simplifies the mechanical and electronic circuit design of the rotating mechanism, makes it easier to automate the switching of sample bearing positions, and improves positioning accuracy.

The sample holder 6 can be equipped at the edge of the disc or hollow disc main body , or can be equipped along a circle centered on the geometric center of the main body, and more than ten sample bearing positions 61 or even more than 50 sample bearing positions 61 can be equipped according to the size of the main body. This allows the sample holder 6 to carry a much larger number of samples than the sample holders of existing electron microscopes, This greatly reduces the operation times of sample replacement, simplifies the operation process of the electron microscope, and is particularly suitable for application scenarios where a large number of small sample sizes are observed.

In an embodiment of this example, the sample holder 6 further includes a first identification mark 62, a second identification mark 63, and a third identification mark 64 set on the main body, where:
the first identification mark 62 and the second identification mark 63 are provided on the upper surface of the main body; and/or
One or more positioning grooves or raised stripes are provided on the upper surface of the first identification mark 62 and the second identification mark 63; and/or
the first identification mark 62 is combined with the second identification mark 63 to construct a positioning coordinate system for sample holder 6; and/or
the third identification mark 64 is configured to indicate the placement direction of the sample holder.

In this embodiment, the first identification mark 62 and the second identification mark 63 are engraved with positioning lines or raised stripes with an accuracy of nanometers on the identification surface. The position relationship between each pixel of the whole image of the sample holder 6 is recorded by taking an optical photo of the whole sample holder 6, and the Cartesian coordinate system of the whole image is determined by using the pixel positions of the first identification mark and the second identification mark in the image, then the positions of all pixels in the image in the coordinate system is determined. The size ratio of the image to the actual object is determined by determining the positional relationship of the pixels of the positioning lines or raised stripes in the image, then the precise positioning and sample measurement is performed. The third identification mark 64 indicates the position of the initial sample bearing positions 61, and the current placement direction of the sample carrier 6 can be identified through the third identification mark 64. The first identification mark 62 and the second identification mark 63 can be made of silicon or metal sheets.

In an embodiment of this example, the sample holder 6 further includes a temperature control structure provided on the main body, and the temperature control structure includes any one or more of the following: pipeline, hidden groove, and resistance slurry pattern. The refrigerant or hot liquid is injected into the pipeline or hidden groove, and the temperature of sample holder 6 is controlled through the flow of refrigerant or hot liquid. The resistance slurry is sprayed onto the main body to form a fixed shape, and the resistance slurry is energized to heat the sample holder 6, controlling the temperature of the sample holder 6, thereby enabling better observation of certain samples with special storage requirements.

In one embodiment of this example, the pipeline includes a circular pipeline provided along a circle centered around the geometric center of the main body.

The hidden groove includes a circular hidden groove provided along a circle centered on the geometric center of the main body.

The resistance slurry pattern is a circular shape provided along a circle centered on the geometric center of the main body, and includes a first insulation layer, a resistance slurry pattern, and a second insulation layer sequentially stacked from the surface of the main body. The pipeline, hidden groove, and resistive material pattern are set in a circular shape centered on the geometric center of the main body, and heat can be transmitted through the main body, then the temperature of the entire main body can be evenly control. The resistance slurry is made of metal material, so it needs to be insulated by wrapping the resistance slurry pattern with an insulation layer.

In an embodiment of this example, the angle between the first direction, the second direction, and the third direction to each other in the sample stage is between 60 ° and 120 °. Alternatively, the first direction, the second direction, and the third direction are orthogonal to each other.

The particular examples mentioned above provide a further detailed explanation of the purpose, technical solution, and beneficial effects of the present invention. It should be understood that the above are only particular examples of the present invention and are not intended to limit it. Any modifications, equivalent replacements, improvements, etc. made within the spirit and principles of the present invention should be included in the scope of protection of the present invention.

## Claims

1. A microscope sample stage, **characterized in that** it comprises:
a base;
a three-dimensional motion mechanism provided on the base, wherein the three-dimensional motion mechanism can move in a first direction, a second direction and a third direction;
a supporting structure, which is provided on the three-dimensional motion mechanism and can rotate about a shaft parallel to the third direction;
a sample holder placement portion, which is provided on the supporting structure; wherein
the supporting structure comprises a locking mechanism, by means of which a sample holder is fixed.

2. The sample stage according to claim 1, **characterized in that** the supporting structure comprises:
a fourth supporting structure, which is provided on the three-dimensional motion mechanism and can rotate about a shaft parallel to the third direction.

3. The sample stage according to any one of claims 1 to 2, **characterized in that** the locking mechanism comprises at least two claw heads and a reset component respectively connected to the claw heads.

4. The sample stage according to claim 3, **characterized in that** the supporting structure comprises a fifth driving mechanism which is configured to drive the locking mechanism locking or unlocking.

5. The sample stage according to claim 4, **characterized in that** the fifth driving mechanism comprises a transmission component, a steering component, and a power component, wherein one end of the transmission component contacts the claw heads in a locked state and drives the claw heads to move outward along the cross-sectional center of the supporting structure, detaching from the claw heads in an unlocked state; the other end of the transmission component is connected to the steering component; one end of the steering component is connected to the transmission component, and the other end of the steering component is connected to the power component.

6. The sample stage according to any one of claims 1 to 5, **characterized in that** the three-dimensional motion mechanism comprises a first motion mechanism and a second motion mechanism, wherein the first motion mechanism is capable of driving the supporting structure to move in the first direction and the second direction, and the second motion mechanism is capable of driving the supporting structure to move in the third direction.

7. The sample stage according to any one of claims 1 to 6, **characterized in that** the three-dimensional motion mechanism comprises:
a first supporting structure provided on the base and capable of moving in the first direction relative to the base;
a second supporting structure provided on the first supporting structure and capable of moving in the second direction relative to the first supporting structure;
a third supporting structure provided on the second supporting structure and capable of moving in the third direction relative to the second supporting structure.

8. The sample stage according to claim 7, **characterized in that** the upper surface of the base has an inward concave shape and comprises a first guide rail provided in the first direction on the two opposite sidewalls of the concave, and the lower surface of the first supporting structure is provided with a first sliding component that is matched with the first guide rail.

9. The sample stage according to claim 8, **characterized in that** a first driving mechanism is provided on one sidewall of the base, configured to drive the movement of the first supporting structure; and/or
the other sidewall of the base is provided with a first grating ruler, and the lower surface of the corresponding position of the first supporting structure is provided with a grating ruler reading head, configured to measure the relative displacement between the base and the first supporting structure.

10. The sample stage according to claim 7, **characterized in that** the upper surface of the first supporting structure has an inward concave shape, and comprises a second guide rail provided along the second direction on the two opposite sidewalls of the concave, and the lower surface of the second supporting structure has a second sliding component that is matched with the second guide rail.

11. The sample stage according to claim 10, **characterized in that**, a second driving mechanism is provided in the middle depression on the upper surface of the first supporting structure, configured to drive the movement of the second supporting structure; and/or
the other sidewall of the first supporting structure is provided with a first grating ruler, and the lower surface of the corresponding position of the second supporting structure is provided with a grating ruler reading head, configured to measure the relative displacement between the first supporting structure and the second supporting structure.

12. The sample stage according to claim 7, **characterized in that** the third supporting structure is movably connected to the second supporting structure through a fixing portion fixed to the second supporting structure.

13. The sample stage according to claim 12, **characterized in that** a third driving mechanism is provided on the another surface of the fixing portion, which is opposite to the surface of the fixing portion where the third supporting structure is installed, configured to drive the movement of the third supporting structure.

14. The sample stage according to claim 13, **characterized in that** the upper surface of the third supporting structure is provided with a fourth driving mechanism, configured to drive the rotation of the fourth supporting structure.

15. The sample stage according to claim 4 or 5, **characterized in that** the fifth driving mechanism further comprises a sensor.

16. The sample stage according to any one of claims 1 to 15, **characterized in that** it further comprises a sample holder, wherein the sample holder comprises:
main body;
a plurality of sample bearing positions which are provided along the edges of the main body.

17. The sample stage according to claim 16, **characterized in that** the main body is in the shape of a disc or a hollow disc; and/or
the sample bearing positions are provided in a circular shape centered on the geometric center of the main body; and/or
the sample bearing positions are provided equidistantly along the edges of the main body; and/or
the sample holder comprises more than ten sample carrying positions.

18. The sample stage according to claim 16, **characterized in that** it further comprises a first identification mark, a second identification mark, and a third identification mark provided on the main body, wherein:
the first identification mark and the second identification mark are provided on the surface of the main body; and/or
the first identification mark and the second identification mark are provided with one or more positioning lines or raised stripes on the upper surface; and/or
the combination of the first identification mark and the second identification mark is configured to construct a sample holder positioning coordinate system; and/or
the third identification mark is configured to indicate the placement direction of the sample holder.

19. The sample stage according to claim 16, **characterized in that** the sample holder further comprises a temperature control structure provided on the main body, wherein the temperature control structure comprises any one or more of the following: pipelines, hidden grooves, and resistance slurry patterns.

20. The sample stage according to claim 19, **characterized in that** the pipeline comprises a circular pipeline provided along a circle centered on the geometric center of the main body;
the hidden groove comprises a circular hidden groove provided along a circle centered on the geometric center of the main body;
the resistance slurry pattern is in a circular shape provided along a circle centered on the geometric center of the main body, and comprises a first insulation layer, a resistance slurry coating, and a second insulation layer sequentially stacked from the surface of the main body.

21. The sample stage according to any preceding claim, wherein the angle between the first direction, the second direction, and the third direction to each other is between 60 ° and 120 °; or
the first direction, the second direction, and the third direction are orthogonal to each other.
